# EUROPEAN PATENT APPLICATION

(11) **EP 4 654 760 A1**
(43) Date of publication of application: **26.11.2025**
(21) Application number: 24177906.5
(22) Date of filing: 24.05.2024
(51) Int. Cl.: H05K 3/40, H05K 1/14, H01R 12/61, H01R 12/62, H01R 12/68, H01R 12/70, H05K 3/36, H05K 1/11, H05K 1/18

(54) **PRINTED CIRCUIT ARRANGEMENT, METHOD AND APPARATUS FOR PROVIDING A PRINTED CIRCUIT ARRANGEMENT, AND ELECTRIC ASSEMBLY**

(71) Applicant: Lisa Dräxlmaier GmbH, 84137 Vilsbiburg (DE)
(72) Inventor: Grudzien, Szymon, 30-864 Kraków (PL)

(57) **Abstract**

Proposed is a printed circuit arrangement (100). The printed circuit arrangement (100) comprises a flexible printed circuit (110), FPC, comprising a first substrate (112) of a first rigidity and a number of first electrical contacts (114) arranged separately from each other. Further, the printed circuit arrangement (100) comprises a rigid printed circuit board (120), PCB, comprising a second substrate (122) of a second rigidity higher than the first rigidity and a number of second electrical contacts (124) arranged separately from each other. A respective one of the number of first electrical contacts (114) is connected to a corresponding one of the number of second electrical contacts (124) by a crimp contact (130). Further, there is proposed a method for providing a printed circuit arrangement, a corresponding apparatus, and an electric assembly comprising a printed circuit arrangement.

## Description

### Technical Field

The present invention relates to connecting printed circuits and/or printed circuit boards to each other. In particular, the present invention relates to a printed circuit arrangement, a method for providing a printed circuit arrangement, to an apparatus for providing a printed circuit arrangement, and to an electric assembly.

### Technical Background

A flexible printed circuit (FPC) comprises electric and/or electronic components arranged, e.g. mounted, on a flexible substrate made of plastic. Such FPC may replace and/or supplement a, conventionally rigid, printed circuit board (PCB). For example, it is conceivable that one or more FPCs may be connected to one or more PCBs, e.g. to implement a multi-board arrangement, a master-slave arrangement of the corresponding printed circuits, or for other purposes. Accordingly, it may be conceivable to provide a multi-board system comprising at least one FPC and at least one PCB connected to each other.

In practice, it has been shown that the combination of an FPC and a PCB, i.e. the connection thereof, requires at least one interface in between, which is implemented by a connector, one or more cables, or the like. However, a structurally simpler design would be desirable in this regard.

### Summary of Invention

Therefore, an object of the invention is to provide structurally simple means for connecting a flexible printed circuit and a printed circuit board.

This object is solved by the subject-matter of the appended independent claims. Further embodiments are defined in the appended dependent claims, the description below, and the accompanying drawings.

According to a first aspect, there is provided a printed circuit arrangement. It comprises a flexible printed circuit (FPC). The FPC comprises a first substrate of a first rigidity and a number of first electrical contacts arranged separately from each other at an edge section. The printed circuit arrangement further comprises a rigid printed circuit board (PCB). The PCB comprises a second substrate of a second rigidity higher than the first rigidity and a number of second electrical contacts arranged separately from each other at an edge section. A respective one of the number of first electrical contacts is connected to a corresponding one of the number of second electrical contacts by a crimp contact of a number of crimp contacts.

The printed circuit arrangement provided allows for directly connecting an FPC and a PCB to each other using a dedicated crimp contact, which may also be formed and referred to as a splice. Further, the printed circuit arrangement provided allows for at least reducing and/or omitting additional and/or redundant parts, such as a connector, cables, or the like, usually used for connecting an FPC and a PCB to each other. This can save space needed for the printed circuit arrangement. Accordingly, the printed circuit arrangement provided is more cost efficient and smaller than solutions with extra components, e.g. connectors, cables, and cheaper than of-the-shelf rigid-flex PCBs solution. Moreover, the printed circuit arrangement provided is more cost efficient than a rigid-flex stackup designed as one part and is not subject to some design limitations like buried and blind vias of such rigid-flex stackup. Further, the crimp connection, which may be provided as a splice connection, between the respective one of the number of first electrical contacts and the corresponding one of the number of second electrical contacts is more robust against cracking than direct soldering of the contacts, and generally highly robust. Proposed solution can save some space by not using third party connectors. In other words, by using bare material instead of off-the-shelf components the printed circuit arrangement provides is quite cost efficient and environment-friendly, since no single component production process is needed, and the mechanical crimping process is easy. Because of crimp character of the connection, a relaxation of mating surfaces, e.g. caused by different extension temperature coefficient for them can be realized without cracks and strains.

As used herein, the flexible printed circuit (FPC) may be implemented as known in the technical field, so the details do not need to be described herein. Generally, it may be understood as a type of printed circuit board (PCB), where at least a portion of the board is flexible, e.g. bendable. Accordingly, at least a portion of the first substrate may be flexible, e.g. bendable. In other words, the first substrate is more flexible and/or less rigid than the second substrate of the PCB. For example, the first substrate may be made from or may comprise at least one plastic material, such as polyimide, PEEK, polyester, or the like, which may optionally be provided as a film. The FPC may be made with a photolithographic technology, wherein this is not limited herein. As with a PCB, the FPC may comprise a number of electrical devices arranged in a circuit and at least one conductive pattern of conductive traces electrically connecting the number of electrical devices. The number of first contacts may be electrically connected via the at least one conductive pattern. The number of first electrical contacts may be arranged on one and/or both surfaces of the FPC. Multiple, i.e. two or more, first electrical contacts may be provided. The multiple first electrical contacts may be arranged next to each other as a row, similar to a plug connector. In at least some embodiments, the number of first electrical contacts may project beyond the first substrate.

Further, as used herein, the printed circuit board (PCB) may be implemented as known in the technical field, so the details do not need to be described herein. For example, the PCB and/or the second substrate may comprise a laminated sandwich structure of conductive and insulating layers. The second substrate is more rigid than the first substrate of the FPC. The PCB may comprise a number of electrical devices arranged in a circuit and at least one conductive pattern of conductive traces electrically connecting the number of electrical devices. The number of second contacts may be electrically connected via the at least one conductive pattern. The number of second electrical contacts may be arranged on one and/or both surfaces of the PCB. Multiple, i.e. two or more, second electrical contacts may be provided. The multiple second electrical contacts may be arranged next to each other as a row, similar to a plug connector. In at least some embodiments, the number of second electrical contacts may project beyond the second substrate.

As used herein, the crimp contact may be understood as a metal clip, metal strip, or the like, which is crimped onto a respective pair of first electrical contact and second electrical contacts that overlap each other. The crimping technology used for connecting the number of first electrical contacts and the number of second electrical contacts to each other may be understood as a solderless connection of those electrical contacts, where the crimp contact is crimped, e.g. bent and pressed, around the arrangement of a respective first electrical contact and a corresponding second electrical contact. In at least some embodiments, the crimp contact may be formed and/or provided as a splice. That is, the crimping technology used may specifically be a splicing technology, where the crimp contact may be cut out of a band-shaped material, formed, e.g. bent, and then crimped, which may be understood as a process at least similar to pressing of the crimp contact.

It is understood that there is a one-to-one correspondence between the number of first electrical contacts and the number of second electrical contacts. Each pair of first electrical contact and second electrical contact is connected to each other using an individual, dedicated crimp contact.

According to an embodiment, the respective first electrical contact and the corresponding second electrical contact connected may be arranged to overlap each other in a top-down direction. The crimp contact may at least partially enclose both electrical contacts. The top-down direction may refer to a normal through the surface of the FPC and/or PCB. Each pair of first electrical contact and second electrical contact may be arranged one above the other. This allows good electrical contacting over a large area between the respective first and second electrical contact. It also allows a robust connection using the crimp contact.

In an embodiment, an individual of the number of first electrical contacts and/or the number of second electrical contacts may be laterally at least sectionally exposed. This allows the crimp contact to be arranged around the first and second electrical contact in a simple and reliable manner.

According to an embodiment, the number of first electrical contacts and/or the number of second electrical contacts may be formed as a contact pad. This allows good electrical contacting over a large area between the respective first and second electrical contact. It also allows a robust connection using the crimp contact.

In an embodiment, the number of first electrical contacts and/or the number of second electrical contacts may be placed on layers of the respective first substrate or second substrate. The layers may, for example, be external layers of the first substrate and/or the second substrate. The layers may act as mating layers with each other. For example, the layers may be adjustable in terms of their number, thickness, or the like, in order to align the number of first electrical contacts 114 and the number of second electrical contacts 124 with each other.

According to an embodiment, the printed circuit arrangement may further comprise at least one fixing section arranged at the respective number of first electrical contacts and/or number of second electrical contacts, for example, on a side facing away from the respective first substrate and/or second substrate. The at least one fixing section may be configured to be attached to the other one of the first substrate and the second substrate. By way of example, it may be form-fit, force-fit and/or material-fit. The fixing section may be non-conductive. For example, the fixing section may be formed as or may comprise at least one of a substrate, a layer stack section, a reduced layer stack section, a border section, an edge section, or the like. In this way, the fixation between the FPC and the PCB may be more robust.

In an embodiment, the number of crimp contacts may be formed from a band-shaped material and bent around the respective first electrical contact and the corresponding second electrical contact. For example, the band-shaped material may be coiled on a reel or roll and provided from there. Each individual of the number of crimp contacts may be cut from the material, i.e. from the reel, e.g. by using a guillotine or the like. Further, each crimp contact may be formed by bending and/or pressing around the respective first electrical contact and the corresponding second electrical contact. In this way, there may be provided a splice connection, which may be manufactured in a cost efficient and easy manner.

According to an embodiment, the number of first electrical contacts, and/or the number of second electrical contacts may comprise a finishing. In other words, at least one of the FPC and the PCB may comprise a finishing in the area and/or section of the respective number of first electrical contacts or second electrical contacts. The finishing may comprise any finishing other than bare organic solderability preservative (OSP), wherein, in at least some embodiments, bare OSP may be used. In this way, corrosion may be at least reduced or avoided.

In an embodiment, one of the number of first electrical contacts and the number of second electrical contacts may comprise a geometry less than, equal to or bigger than a geometry of the other of the number of first electrical contacts and the number of second electrical contacts . For example, the number of first electrical contacts may be thinner than, thicker than, bigger than, or equal to the number of second electrical contacts.

According to a second aspect, there is provided an electric assembly. The electric assembly comprises at least one electric component. Further, the electric assembly comprises a printed circuit arrangement according to the first aspect operationally coupled to the at least one electric component.

For example, the electric assembly may form or may be part of an electric and/or electronic device comprising a multi-board arrangement, i.e. the printed circuit arrangement according to the first aspect. Examples of the electric assembly may provide or may be used for ambient lighting, charging ports, a power distribution network, a lighting system, high voltage batteries, for example, in a vehicle. When applied to a vehicle, the printed circuit arrangement according to the first aspect provides a robust, e.g. vibration-resistant, and cost-efficient connection of an FPC and a PCB. It is understood, however, that the printed circuit arrangement may be applied to a wide variety of other industrial applications and/or electric devices. For further embodiments and modifications of the electric assembly reference is made to the first aspect.

According to a third aspect, there is provided a method of providing a printed circuit arrangement. The method comprises providing flexible printed circuit (FPC) comprising a first substrate of a first rigidity and a number of first electrical contacts arranged separately from each other at an edge section. Further, the method comprises providing a rigid printed circuit board (PCB) comprising a second substrate of a second rigidity higher than the first rigidity and a number of second electrical contacts arranged separately from each other at an edge section. In addition, the method comprises arranging a crimp contact to connect a respective one of the number of first electrical contacts to a corresponding one of the number of second electrical contacts.

The method allows for providing, e.g. manufacturing, a printed circuit arrangement, e.g. of the printed circuit arrangement according to the first aspect in an easy and cost-efficient way. For further embodiments and modifications of the electric assembly reference is made to the above aspects.

In an embodiment, the crimp contact may be cut from a band-shaped material. For example, a cutting device may be used for this purpose. The band-shaped material may be provided from a reel or roll. In this way, the solderless connection between the FPC and the PCB, i.e. between the number of first contacts and the number of second contacts, may be provided in form of a splice. This can be implemented in a simple and cost-efficient manner.

According to an embodiment, the crimp contact may be bent around the respective one of the number of first electrical contacts and the corresponding one of the number of second electrical contacts. For example, a bending device may be used for this purpose. The bending device may comprise a jig, optionally a dedicated jig for each pair of first and second electrical contact. This can be implemented in a simple and cost-efficient manner.

According to a fourth aspect, there is provided an apparatus for providing a printed circuit arrangement. The apparatus comprises a handling device configured to position a flexible printed circuit, FPC, comprising a first substrate of a first rigidity and a number of first electrical contacts arranged separately from each other and a rigid printed circuit board, PCB, comprising a second substrate of a second rigidity higher than the first rigidity and a number of second electrical contacts arranged separately from each other. Further, the apparatus comprises a cutting device configured to cut a band-shaped material into pieces to provide a number of crimp contacts. In addition, the apparatus comprises a bending device configured to bend the crimp contact around a respective one of the number of first electrical contacts and a corresponding one of the number of second electrical contacts. The apparatus may, for example, also form or be part of an at least semi-automated crimping device or may comprise one or more components of such crimping device. Further, it may be an integral system or a distributed system.

In an embodiment, the apparatus may further comprise a provisioning device configured to provide the band-shaped material from a reel to the cutting device.

The apparatus allows for providing, e.g. manufacturing, a printed circuit arrangement, e.g. of the printed circuit arrangement according to the first aspect in an easy and cost-efficient way. For further embodiments and modifications of the electric assembly reference is made to the above aspects.

The aspects, embodiments, variants, and examples described above may, of course, be combined without this being explicitly described. Each of the described further embodiments and each example are thus optional to each of the aspects, embodiments, variants, and examples or already combinations thereof. The present disclosure is thus not limited to the individual embodiments and embodiment variants in the described order or to a particular combination of the aspects and embodiment variants.

### Brief Description of Drawings

In the following, embodiments of the invention are explained with reference to the accompanying drawings. It shows:
Fig. 1 in a schematic top view an exemplary printed circuit arrangement according to an embodiment.
Fig. 2 in a schematic top view an exemplary printed circuit arrangement according to an embodiment during its assembly.
Fig. 3 in a schematic top view an exemplary printed circuit arrangement according to an embodiment.
Figs. 4A to 4D an exemplary process for providing a crimp contact for use for a printed circuit arrangement according to an embodiment.
Fig. 5 in a schematic side view an exemplary apparatus for providing a printed circuit arrangement according to an embodiment.
Fig. 6 in a schematic block diagram an exemplary electric assembly according to an embodiment.
Fig. 7 in a flowchart a method for providing a printed circuit arrangement according to an embodiment.

The drawings are merely schematic illustrations and serve only to explain the invention. Identical or similarly functioning elements are provided with the same reference signs.

### Detailed Description of Embodiments

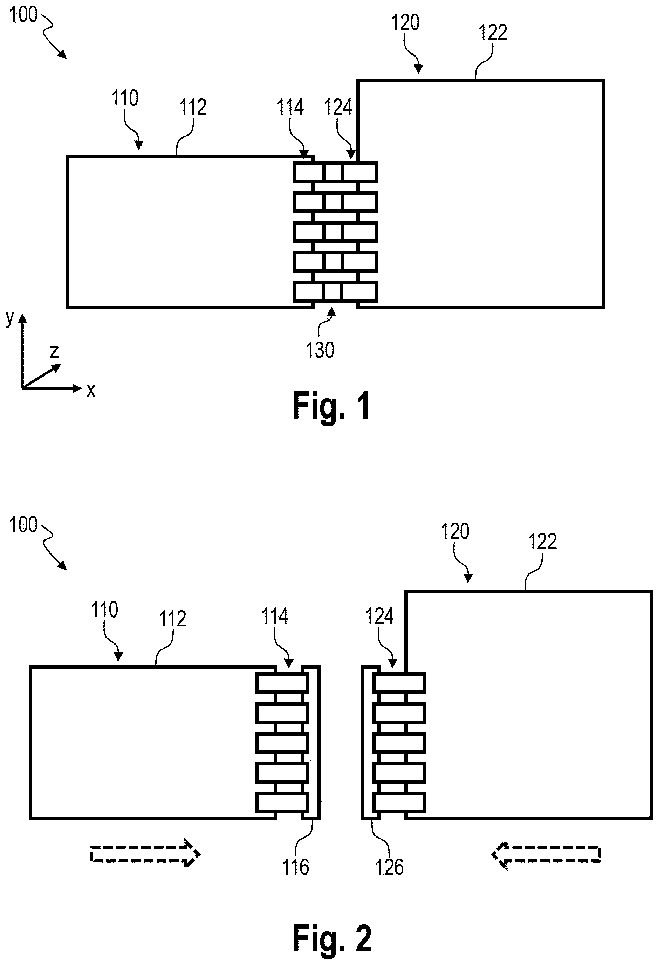

Fig. 1 shows in a schematic top view an exemplary printed circuit arrangement 100. The printed circuit arrangement 100 forms a multi-board arrangement that may be used to implement various electric and/or electronic functionalities.

The printed circuit arrangement 100 comprises a flexible printed circuit (FPC) 110. The FPC 110 comprises a first substrate 112 of a first rigidity. In addition, the FPC 110 comprises a number of first electrical contacts 114 arranged separately from each other. Generally, the number of first electrical contacts 114 may be arranged and/or formed anywhere within or at the FPC 110. For example, the number of first electrical contacts 114 may be arranged at an edge section of the FPC 110 and/or the first substrate 112, as illustrated in Fig. 1.

Further, the printed circuit arrangement 100 comprises a rigid printed circuit board (PCB) 120. The PCB 120 comprises a second substrate 122 of a second rigidity higher than the first rigidity. In addition, the PCB 120 comprises a number of second electrical contacts 124 arranged separately from each other. Generally, the number of second electrical contacts 124 may be arranged and/or formed anywhere within or at the PCB 120. For example, the number of second electrical contacts 124 may be arranged at an edge section of the PCB 120 and/or the second substrate 122, as illustrated in Fig. 1.

In addition, in the printed circuit arrangement 100, a respective one of the number of first electrical contacts 114 is connected to a corresponding one of the number of second electrical contacts 124 by a crimp contact 130 of a number of crimp contacts.

It is noted that there is a one-to-one correspondence between the number of first electrical contacts 114 and the number of second electrical contacts 124. Also, there is a one-to one-correspondence between each pair of first electrical contact 114 and second electrical contact 124 and the corresponding crimp contact 130. In the example according to Fig. 1, there are five first electrical contacts 114 and five second electrical contacts 124, and each pair of first electrical contact 114 and second electrical contact 124 is connected to each other by the dedicated crimp contact 130.

As indicated in Fig. 1, the respective first electrical contact 114 and the corresponding second electrical contact 124 connected may be arranged to overlap each other in a top-down direction, i.e. the z-direction in Fig. 1. The crimp contact 130 may at least partially enclose both electrical contacts 114, 124, i.e. each pair of first electrical contact 114 and second electrical contact in a one-by-one correspondence. The top-down direction may refer to a normal through the surface of the FPC and/or PCB, corresponding to the z-direction in Fig. 1. Each pair of first electrical contact 114 and second electrical contact 124 may be arranged one above the other, or otherwise adjacent to and/or overlapping with each other, and the crimp contact may be arranged around them. Further, one of the number of first electrical contacts 114 and the number of second electrical contacts 124 may comprise a geometry less than, bigger than, or equal to a geometry of the other of the number of first electrical contacts 114 and the number of second electrical contacts 124. For example, the number of first electrical contacts 114 may be thinner than, bigger than, or equal to the number of second electrical contacts 124, or vice versa.

Further, as indicated in Fig. 1, an individual of the number of first electrical contacts 114 and/or the number of second electrical contacts 124 may be laterally at least sectionally exposed. In other words, space between each two electrical contacts may be provided. For example, it may be milled out or the like. Accordingly, a space between each adjacent electrical contacts 114, 124 may be milled out or the like to provide space for crimping. In addition, for example, at least part of the number of first electrical contacts 114 and/or the number of second electrical contacts 124 may be formed as flat electrical contacts, wherein this is not limited herein.

In at least some embodiments, the number of first electrical contacts 114 and/or the number of second electrical contacts 124 may be formed as a contact pad. Further, in at least some embodiments, the number of first electrical contacts 114 and/or the number of second electrical contacts 124 may be placed on layers of the respective first substrate and/or second substrate. This may, for example, be external layers of the first substrate 112 and/or the second substrate 122. The layers may act as mating layers with each other. For example, the layers may be adjustable in terms of their number, thickness, or the like, in order to align the number of first electrical contacts 114 and the number of second electrical contacts 124 with each other.

Further, in at least some embodiments, the number of crimp contacts 130 may be formed from a band-shaped material and bent around the respective first electrical contact 114 and the corresponding second electrical contact 124. For example, the band-shaped material may be coiled on a reel or roll and provided from there. The band-shaped material may be cut in pieces, wherein each piece may be used to form one crimp contact 130. Further, each crimp contact 130 may be formed by bending and/or pressing a piece cut from the band-shaped material around the respective first electrical contact and the corresponding second electrical contact.

In at least some embodiments, the edge section of the number of first electrical contacts 114 and/or the edge section of the number of second electrical contacts 124 may comprise a finishing. In other words, at least one of the FPC 110 and the PCB 120 may comprise a finishing in the area of the respective number of first electrical contacts 114 or second electrical contacts 124. The finishing may comprise any finishing other than bare organic solderability preservative (OSP), wherein, in at least some embodiments, bare OSP may be used.

Fig. 2 shows another example of the printed circuit arrangement 100. Dashed arrows indicate the direction in which the FPC 110 and the PCB 120 are brought towards each other in order to then connect them to each other by means of the number of crimp contacts 130 (not shown here) as well as the number of first electrical contacts 114 and the number of second electrical contacts 124.

Basically, the example according to Fig. 2 differs from that shown in Fig. 1 in that the printed circuit arrangement 100 may further comprise at least one fixing section 116, 126. By way of example, the fixing section may be electrically non-conductive. It is noted that although Fig. 2 shows two fixing sections 116, 126, only one of the FPC 110 and the PCB 120 may comprise such fixing section 116 or 126. For example, the fixing section may be formed as or may comprise at least one of a substrate, a layer stack section, a reduced layer stack section, a border section, an edge section, or the like.

The at least one fixing section 116, 126 may be arranged at the respective edge section of the number of first electrical contacts 114 and/or the number of second electrical contacts 124 on a side facing away from the respective first substrate 112 and/or second substrate 122. The at least one fixing section 116, 126 may be configured to be attached to the other one of the first substrate 112 and the second substrate 122.

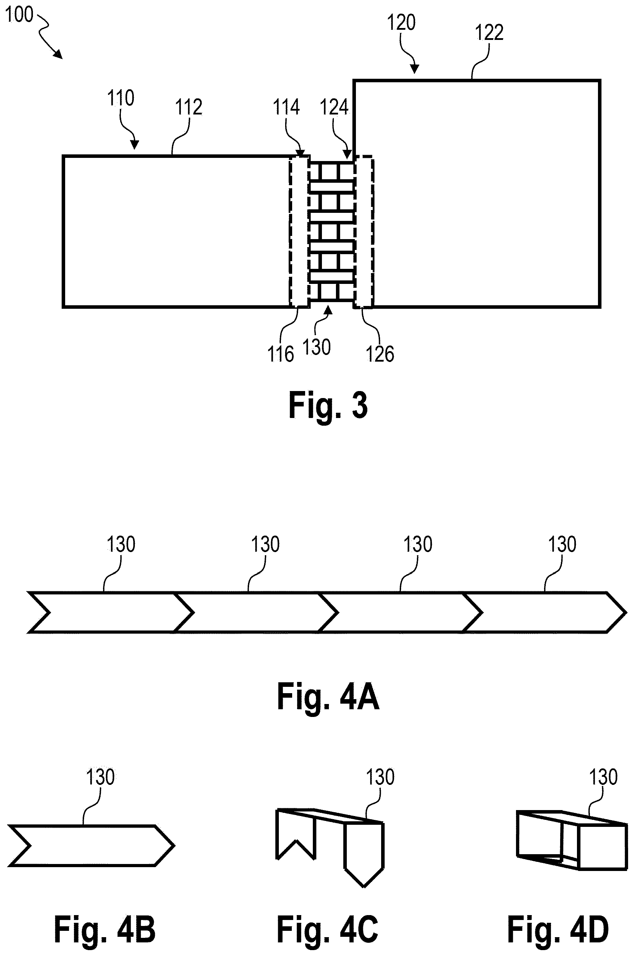

Fig. 3 shows the printed circuit arrangement 100 according to Fig. 2 after connecting the number of first contacts 114 and the number of second contacts 124 by means of the corresponding number of crimp contacts 130.

As indicated in Fig. 3, the at least one fixing section 116, 126 is attached to the other of the FPC 110 and the PCB 120 and serves at least primarily as an additional fixation.

Figs. 4A to 4D illustrate an exemplary process for providing the above-mentioned crimp contact 130 for use in the printed circuit arrangement 100.

Referring to Fig. 4A, as mentioned above, the number of crimp contacts, i.e. each crimp contact 130, may be formed from a band-shaped material. For example, the band-shaped material may be coiled on a reel or roll and provided from there.

Further, referring to Fig. 4B, the band-shaped material may be cut in pieces, wherein each piece may be used to form one crimp contact 130. It is understood that each piece may have a dedicated length. Depending on whether the geometries of the pairs of first electrical contact 114 and second electrical contact 124 are different or identical to each other, the crimp contacts 130 may also be different or of the same length and/or width.

In addition, referring to Fig. 4C, each piece used to form the respective crimp contact 130 may be bent, e.g. by using a jig, around the respective first electrical contact 114 and the corresponding second electrical contact 124.

Fig. 4D illustrates the final state of the crimp contact 130 after bending it around the respective first electrical contact 114 and the corresponding second electrical contact 124, wherein for better illustration the first electrical contact 114 and second electrical contact 124 are not shown here.

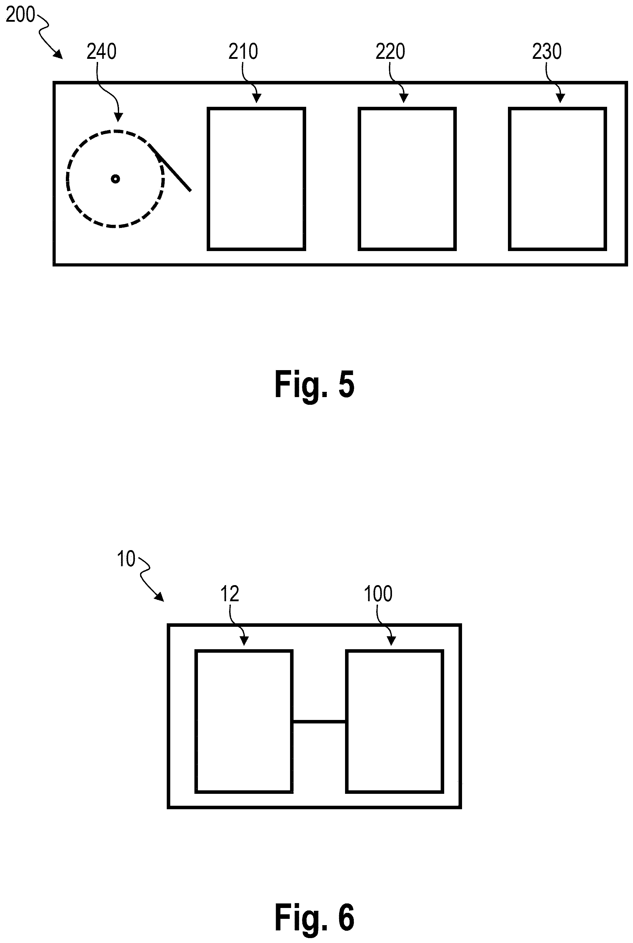

Fig. 5 illustrates in a schematic block diagram an exemplary apparatus 200 for providing the printed circuit arrangement 100.

The apparatus 200 comprises a handling device 210 configured to position a flexible printed circuit (FPC), i.e. the FPC 110, comprising a first substrate of a first rigidity and a number of first electrical contacts arranged separately from each other at an edge section and a rigid printed circuit board (PCB), i.e. the PCB 120, comprising a second substrate of a second rigidity higher than the first rigidity and a number of second electrical contacts arranged separately from each other. It is noted that such positioning is apparent from Fig. 1 and Fig. 2. For example, the FPC and the PCB may be arranged with their respective electrical contacts overlapping each other in a one-to-one correspondence. For example, the handling device 210 may comprise at least one gripper or the like.

Further, still referring to Fig. 5, the apparatus 200 comprises a cutting device 220 configured to cut a band-shaped material into pieces to provide a crimp contact, i.e. the crimp contact 130. It is noted that such cutting from band-shaped material is illustrated in Fig. 4A, showing the band-shaped material before cutting, and Fig. 4B showing the individual crimp contact after cutting. For example, the cutting device 220 may comprise at least one of a blade, a knife, a guillotine, or the like.

In addition, still referring to Fig. 5, the apparatus 200 comprises a bending device 230 configured to bend the crimp contact around a respective one of the number of first electrical contacts and a corresponding one of the number of second electrical contacts. For example, the bending device 230 may comprise a number of actuators or the like, a chuck or the like,

In at least some embodiments, the apparatus 200 may comprise a provisioning device 240 configured to provide the band-shaped material from a reel to the cutting device 220.

Further, by way of example, the apparatus may also form or be part of an at least semi-automated crimping device or may comprise one or more components of such crimping device. Further, it may be an integral system or a distributed system.

Fig. 6 illustrates in a schematic block diagram an exemplary electric assembly 10. For example, the electric assembly 10 may form or may be part of an electric and/or electronic device comprising a multi-board arrangement, i.e. the printed circuit arrangement according to the first aspect. Examples of the electric assembly may provide or may be used for ambient lighting, charging ports, a power distribution network, a lighting system, high voltage batteries, for example, in a vehicle, wherein this is not limited herein.

The electric assembly 10 comprises at least one electric component 12. Further, the electric assembly comprises the printed circuit arrangement 100 according to at least one of the embodiments described herein. The printed circuit arrangement 100 is coupled to the at least one electric component 12. The printed circuit arrangement 100 is configured to control at least one function of the at least one electric component.

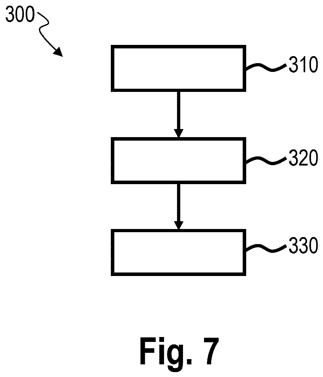

Fig. 7 illustrates in a flow chart a method 300 for providing a printed circuit arrangement, e.g. the printed circuit arrangement 300.

The method 300 comprises providing 310 flexible printed circuit, FPC, comprising a first substrate of a first rigidity and a number of first electrical contacts arranged separately from each other at an edge section. Further, the method comprises providing 320 a rigid printed circuit board, PCB, comprising a second substrate of a second rigidity higher than the first rigidity and a number of second electrical contacts arranged separately from each other at an edge section. In addition, the method comprises arranging 330 a crimp contact to connect a respective one of the number of first electrical contacts to a corresponding one of the number of second electrical contacts. It is noted that the above method steps do not necessarily have to be carried out in a fixed order. For example, the FPC 110 and the PBC 120 may be provided in any order.

In at least some embodiments, the crimp contact may be cut from a band-shaped material provided from a reel. Further, the crimp contact may be bent around the respective one of the number of first electrical contacts and the corresponding one of the number of second electrical contacts.

The aspects, embodiments, variants, and examples described above may, of course, be combined without this being explicitly described. Each of the described further embodiments and each example are thus optional to each of the aspects, embodiments, variants, and examples or already combinations thereof. The present disclosure is thus not limited to the individual embodiments and embodiment variants in the described order or to a particular combination of the aspects and embodiment variants.

### REFERENCE SIGNS LIST

- 10: electric assembly
- 12: electric component
- 100: printed circuit assembly
- 110: flexible printed circuit (FPC)
- 112: (first) substrate
- 114: (first) electrical contact
- 116: (first) fixing section
- 120: printed circuit board (PCB)
- 122: (second) substrate
- 124: (second) electrical contact
- 126: (second) fixing section
- 130: crimp contact
- 200: apparatus
- 210: handling device
- 220: cutting device
- 230: bending device
- 240: provisioning device
- 300: method
- 31x: method step(s)

## Claims

1. A printed circuit arrangement (100), comprising:
a flexible printed circuit (110), FPC, comprising a first substrate (112) of a first rigidity and a number of first electrical contacts (114) arranged separately from each other; and
a rigid printed circuit board (120), PCB, comprising a second substrate (122) of a second rigidity higher than the first rigidity and a number of second electrical contacts (124) arranged separately from each other;
wherein a respective one of the number of first electrical contacts (114) is connected to a corresponding one of the number of second electrical contacts (124) by a crimp contact (130).

2. The printed circuit arrangement of claim 1, wherein the respective first electrical contact (114) and the corresponding second electrical contact (124) connected are arranged to overlap each other in a top-down direction, and the crimp contact (130) at least partially encloses both electrical contacts (112, 122).

3. The printed circuit arrangement of claim 1 or 2, wherein an individual of the number of first electrical contacts (114) and/or the number of second electrical contacts (124) is laterally at least sectionally exposed.

4. The printed circuit arrangement of any one of the preceding claims, wherein the number of first electrical contacts (114) and/or the number of second electrical contacts (124) is formed as a contact pad.

5. The printed circuit arrangement of any one of the preceding claims, wherein the number of first electrical contacts (114) and/or the number of second electrical contacts (124) is placed on layers of the respective first substrate (112) and second substrate (122).

6. The printed circuit arrangement of any one of the preceding claims, further comprising at least one fixing section (116, 126) arranged at the respective number of first electrical contacts (114) and/or number of second electrical contacts (124) on a side facing away from the respective first substrate (112) and/or second substrate (114), wherein the at least one fixing section (116, 126) is configured to be attached to the other one of the first substrate (112) and the second substrate (122).

7. The printed circuit arrangement of any one of the preceding claims, wherein the number of crimp contacts (130) is formed from a band-shaped material and bent around the respective first electrical contact (114) and the corresponding second electrical contact (124).

8. The printed circuit arrangement of any one of the preceding claims, wherein the number of first electrical contacts (114) and/or the number of second electrical contacts (124) comprises a finishing.

9. The printed circuit arrangement of any one of the preceding claims, wherein one of the number of first electrical contacts (114) and the number of second electrical contacts (124) comprises a geometry less than, equal to or bigger than a geometry of the other of the number of first electrical contacts (114) and the number of second electrical contacts (124).

10. An electric assembly (10), comprising:
at least one electric component (12); and
a printed circuit arrangement (100) according to any one of the preceding claims coupled to the at least one electric component (12);
wherein the printed circuit arrangement (100) is configured to control at least one function of the at least one electric component (12).

11. A method (300) of providing a printed circuit arrangement, comprising:
providing (310) flexible printed circuit, FPC, comprising a first substrate of a first rigidity and a number of first electrical contacts arranged separately from each other;
providing (320) a rigid printed circuit board, PCB, comprising a second substrate of a second rigidity higher than the first rigidity and a number of second electrical contacts arranged separately from each other; and
arranging (330) a crimp contact to connect a respective one of the number of first electrical contacts and a corresponding one of the number of second electrical contacts.

12. The method of claim 11, wherein the crimp contact is cut from a band-shaped material provided from a reel.

13. The method of claim 11 or 12, wherein the crimp contact is bent around the respective one of the number of first electrical contacts and the corresponding one of the number of second electrical contacts.

14. An apparatus (200) for providing a printed circuit arrangement, comprising:
a handling device (210) configured to position a flexible printed circuit, FPC, comprising a first substrate of a first rigidity and a number of first electrical contacts arranged separately from each other and a rigid printed circuit board, PCB, comprising a second substrate of a second rigidity higher than the first rigidity and a number of second electrical contacts arranged separately from each other;
a cutting device (220) configured to cut a band-shaped material into pieces to provide a crimp contact;
a bending device (230) configured to bend the crimp contact around a respective one of the number of first electrical contacts and a corresponding one of the number of second electrical contacts.

15. The apparatus of claim 14, further comprising a provisioning device (240) configured to provide the band-shaped material from a reel to the cutting device (220).
